(19) **Europäisches Patentamt**

**European Patent Office**

**Office européen des brevets**

(11) **EP 1 050 900 A1**

(12) **EUROPEAN PATENT APPLICATION**
published in accordance with Art. 158(3) EPC

(43) Date of publication:
08.11.2000 Bulletin 2000/45

(51) Int. Cl.⁷: **H01L 21/027**

(21) Application number: **99900346.0**

(86) International application number:
**PCT/JP99/00142**

(22) Date of filing: **19.01.1999**

(87) International publication number:
**WO 99/36950 (22.07.1999 Gazette 1999/29)**

(84) Designated Contracting States:
**AT BE CH CY DE DK ES FI FR GB GR IE IT LI LU MC NL PT SE**

(30) Priority: **19.01.1998 JP 712898**

(71) Applicant: **Nikon Corporation**
**Tokyo 100-8331 (JP)**

(72) Inventors:
• **TOKUDA, Noriaki,**
**Nikon Corporation**
**Tokyo 100-8331 (JP)**

• **HAGIWARA, Shigeru,**
**Nikon Corporation**
**Tokyo 100-8331 (JP)**

(74) Representative: **Gill, David Alan**
**W.P. Thompson & Co.,**
**Celcon House,**
**289-293 High Holborn**
**London WC1V 7HU (GB)**

(54) **EXPOSURE SYSTEM, EXPOSURE APPARATUS, AND COATING DEVELOPING EXPOSURE APPARATUS**

(57)    An exposure system of the invention comprises: a first unit incorporating a first apparatus for transferring an image of a pattern of a mask onto a substrate, a second unit incorporating a second apparatus having a function different from that of the first apparatus, and a connection unit for connecting the first unit and the second unit, and is characterized in that an internal pressure of the connecting section is set to be lower that an internal pressure of either of the first unit and the second unit, and is set to be higher than a pressure of the surroundings in which the connection unit is installed.

**FIG. 1**

## Description

TECHNICAL FIELD

The present invention relates to an exposure system and exposure apparatus having a light source such as an ArF excimer laser, used in a lithography process for manufacturing semiconductor elements or liquid crystal substrates and the like.

Furthermore, the present invention relates to a projection exposure apparatus used in the manufacture of semiconductor elements and liquid crystal display elements and the like, and a coating and developing apparatus for a photosensitive material (photoresist), used connected to the projection exposure apparatus.

BACKGROUND ART

In the lithography process for manufacturing semiconductor devices or liquid crystal substrates and the like, an exposure apparatus which exposes a pattern image of a reticle (mask) on a photosensitive substrate via a projection optical system is used.

Recently, development towards the miniaturization of semiconductor integrated circuits has progressed, and in the lithography process, there has been an advance in shortening the wavelength of the lithography light source, as a device of achieving even greater miniaturization. Presently, an exposure apparatus which adopts a KrF excimer laser of 248 nm wavelength as a stepper light source has already been developed. Moreover, the higher harmonics of wavelength variable lasers such as a Ti sapphire laser, quadruple higher harmonics of a YAG laser of 266 nm wavelength, quintuple higher harmonics of a YAG laser of 213 nm wavelength, mercury lamps with a wavelength in the neighborhood of 220 nm or 184 nm, and ArF excimer lasers of 193 nm wavelength, are receiving attention as candidates for short wavelength light sources.

In a conventional exposure apparatus with a g line, i line, KrF excimer laser, or a mercury lamp which irradiates light in the vicinity of 250 nm wavelength, as a light source, the emission spectrum lines for these light sources do not overlap the oxygen absorption spectrum region. Hence there is no drop in efficiency for light utilization due to oxygen absorption, or any impairment attributable to the occurrence of ozone due to oxygen absorption. Consequently, with these exposure apparatus, basically, exposure in atmospheric air is possible.

However, with a light source of for example an ArF excimer laser, the emission spectrum lines become the oxygen absorption spectral range. Hence the abovementioned drop in efficiency for light utilization due to oxygen absorption, and the occurrence of an impairment attributable to the generation of ozone due to oxygen absorption occurs. For example, if the light transmittance of ArF excimer laser radiation in a vacuum or in an inert gas such as nitrogen or helium is 100%/m, in a freelance condition (spontaneous emission condition) that is, with an ArF wide band laser, this becomes approximately 90%/m, and even in the case where an ArF narrow band laser with the spectrum width narrow, and which avoids the oxygen absorption lines is used, the light transmittance drops to approximately 98%/m.

The drop in light transmittance is considered to be due to the influence of absorption due to oxygen and generated ozone. Not only does the generation of ozone exert a detrimental influence on light transmittance (efficiency for light utilization), but apparatus performance is impaired due to reaction with the surface of optical members or other parts, and the problem of contamination of the surrounding environment arises. Therefore, in an exposure apparatus which uses a light source of an ArF excimer laser or the like, in order to avoid a drop in light transmittance or the occurrence of ozone, it is necessary to fill (purge) the entire optical path with an inert gas such as nitrogen.

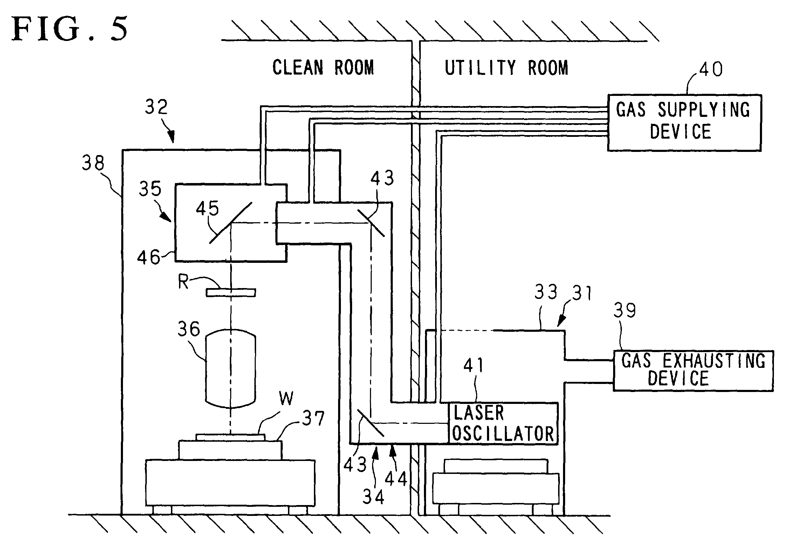

An example of an exposure apparatus having a light source such as an ArF excimer laser is shown in FIG. 5.

In FIG. 5, reference symbol 31 denotes a laser unit, 32 an exposure apparatus main body, 33 a chamber for accommodating the laser unit 31 thereinside, 34 a light transmission system for transmitting laser radiation irradiated from the laser unit 31 to the exposure apparatus main body 32, 35 an illumination optical system for irradiating laser radiation transmitted through the light transmission system 34 towards a reticle R, 36 a projection optical system for projecting a pattern image of the reticle R which is illuminated by the illumination optical system 35 onto a wafer W, 37 a wafer stage for moving the wafer W in two horizontal directions, 38 a chamber for accommodating the exposure apparatus body 32 inside, 39 a gas exhausting device for exhausting gas from inside the chamber, and 40 a gas supplying device for separately supplying nitrogen gas to each of the light transmission system 34 and the illumination optical system 35.

The laser unit 31 comprises a laser oscillator 41 which incorporates a laser reaction chamber including a narrow band module and a discharging electrode (neither shown in the figure), and a chamber 33 for accommodating these. The narrow band module comprises for example, an assembly of a prism and diffraction grating, and optical elements such as an interference type wide bandpass filter with two plane mirrors arranged in parallel (referred to as a Fabry-Perot etalon).

These narrow band modules are accommodated inside an optics chamber (not shown in the figure) which is filled with an inert gas such as a nitrogen. The inert gas is supplied from the beforementioned gas supplying device 40 to inside the optics chamber via piping (not shown in the figure). Furthermore, the laser reaction chamber is filled with a reactive gas such as F$_2$ (fluorine), krypton (Kr), Ne (neon) or the like. Then, by applying a prescribed voltage to the discharge electrodes, laser radiation oscillates from the laser reaction chamber, and this laser radiation is adjusted to a desired wavelength by the narrow band module.

The light transmission system 34 comprises a plurality of optical members including a mirror 43. The respective optical members are arranged inside a lens barrel 44 which covers the light path. The illumination optical system 35 comprises optical members including a mirror 45, and a fly eye lens and a field stop (neither shown in the figure). These respective optical members also, as with the light transmission system 34, are arranged inside a casing 46 covering the light path.

Consequently, the entire optical path of the exposure light is enclosed by the lens barrel 43 and the casing 46.

According to the abovementioned exposure apparatus, nitrogen gas is supplied separately from the gas supplying device 40 to each of the optics chambers for the laser oscillator (not shown in the figure), the lens barrel 44 accommodating the light transmission system 34, and the casing 46 accommodating the illumination optical system 35, so that the entire light path in the laser oscillator, the light transmission system, and the illumination system is purged with nitrogen gas.

Here, with the lens barrel 44 and the casing 46, since the construction thereof is not a completely gas tight structure, there is a space between the optical members accommodated thereinside, and by device of this space, gas can go in and out between the lens barrel 44 and the casing 46. Moreover, since there are screw holes or gaps in the lens barrel 44 and the casing 46 for adjusting the position of the various optical members respectively accommodated thereinside, the gas inside the lens barrel 44 can go in and out of the clean room, the chamber 38 and the chamber 33. Therefore, at the time of performing nitrogen gas purge, high purity nitrogen gas is supplied from the gas supplying device 40, and in order to exhaust the air and impure gas which has already entered into the respective spaces from the abovementioned gaps, the pressure of the respective spaces is set higher than the outside pressure. Consequently, the nitrogen gas for purging the entire optical path of the exposure light is exhausted from the lens barrel 44 and the casing 46, and part thereof flows out to the chamber 38 and the clean room, and with this the inflow of air from the chamber 38 and the clean room is prevented.

Furthermore, with the abovementioned exposure apparatus, fluorine gas is used in the laser reaction chamber inside the laser unit 31, and in order to ensure safety, usually the gas inside the chamber 33 which accommodates the laser oscillator 41 is exhausted to the outside via the gas (casing) exhausting device 39 incorporating processing equipment (not shown in the figure). That is to say, this is provided for discharging fluorine gas from the gas reaction chamber.

However, in the case where the gas inside the chamber 33 is exhausted using the gas exhausting device, when the degree of closure of the optics chamber and the lens barrel 44 is low (the flow of nitrogen gas from the gaps is large) there is the possibility that the nitrogen gas from the optics chamber and the lens barrel 44 is discharged to the chamber 33, reducing the degree of negative pressure by the gas exhausting device 39, so that the pressure inside the lens barrel 44 drops, and at the same time the pressure inside the casing 46 communicated with these drops. Furthermore, if the pressure inside the casing 46 and the lens barrel 44 is lower than the pressure of the exposure apparatus body 32 or the clean room, there is the possibility that the air inside the clean room flows into the casing 46 and the lens barrel 44 from the abovementioned screw holes or gaps. In particular, the air inside the clean room contaminates the lens barrel 44.

While the air inside the clean room is sufficiently purified, compared to the respective purge spaces inside the casing 46 and the lens barrel 44, the oxygen concentration is much higher. Therefore, by introducing the air inside the clean room to inside the casing 42, 46 and the lens barrel 44, the light transmittance of the laser radiation drops. Furthermore, there is a problem of a deterioration in equipment performance due to reaction with the optical element surfaces or other components.

The present invention takes into consideration the abovementioned situation, with the object of continuously performing stabilized exposure processing in an exposure apparatus having a light source of ArF excimer laser or the like, by always keeping the condition of the inert gas filled into the light transmission system constant, and thus maintaining a high light transmittance for the laser radiation.

Furthermore, a lithography process for manufacturing semiconductor devices and the like comprises in general: (1) a step for coating a photosensitive material onto a substrate; (2) a step for projection exposing via a projection optical system and by illumination using exposure light an image of a pattern formed on a mask, onto the substrate to which the photosensitive material has been coated in step (1); and (3) a step for developing the photosensitive material on the substrate on which the image of the pattern has been projection exposed by step (2). Of these steps, typically steps (1) and (3) are realized by a coating and developing apparatus (coater/developer) installed inside a clean room, and step (2) is realized by a projection exposure apparatus installed inside the clean room. Furthermore, in order to shorten the transfer time for the substrate between the coating and developing apparatus and the projection exposure apparatus, and to prevent contamination of the substrate caused during the transfer step, it is relatively common to install the coating and developing apparatus and the projection exposure apparatus inside the clean room connected to each other rather than being installed apart. This equipment configuration with the apparatus connected to each other is generically referred to as a coating and developing exposure apparatus.

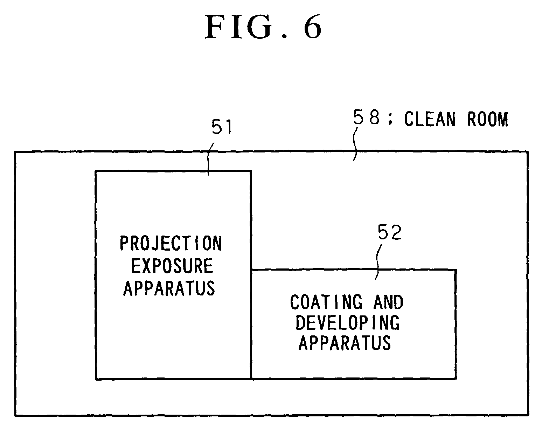

FIG. 6 shows a connected condition (in-line configuration) for this conventional projection exposure apparatus and coating and developing apparatus. The configuration is such that a substrate is transferred between a coating and developing apparatus 52 and a projection exposure apparatus 51 by device of an internally provided substrate transport apparatus (not shown in the figure).

By carrying out various steps of coating a photosensitive material onto a substrate, exposing an image of a pattern of a mask onto the substrate, and developing the photosensitive material, successively inside the coating and developing apparatus as described above with the in-line configuration where the projection exposure apparatus and the coating and developing apparatus are connected together, the substrate is isolated from the atmosphere of the clean room. Hence contaminating substances inside the clean room do not affect the substrate. However, in the coating and developing apparatus, since in general various chemicals are used for process treatment, the chemicals pass through the connecting portions of the in-line structure, and infiltrate into the projection exposure apparatus. Hence there is a problem in that the substrate inside the projection exposure apparatus is contaminated, and a desired semiconductor element or the like cannot be produced.

Furthermore, recently, in particular in order to improve the resolution of the projection optical system so as to correspond to the high integration of semiconductor elements and the like, a projection exposure apparatus (referred to hereunder as an excimer exposure apparatus) which uses an excimer laser (for example a KrF excimer laser of wavelength 248 nm) being a light source of a shorter wave length than the conventional g-line, i-line, mercury lamp etc., as a light source for exposure illumination light is coming into wide use. Moreover, recently, for the photosensitive material (photoresist) applicable to an excimer exposure apparatus, a product referred to as a chemical amplification type resist has become popular. This chemical amplification type resist however has the characteristic that the amplification operation thereof is considerably impaired by basic substances contained in the atmosphere.

Consequently, in order to prevent this impairment of the amplification operation, by carrying out the various steps of coating a photosensitive material onto a substrate, exposing an image of a pattern of a mask onto the substrate, and developing the photosensitive material, successively inside the coating and developing apparatus as described above with the in-line configuration where the projection exposure apparatus and the coating and developing apparatus are connected together, the substrate is isolated from the atmosphere of the clean room. Hence basic substances inside the clean room do not affect the substrate. Together with this, in order to suppress the presence of basic substances inside the projection exposure apparatus and the coating and developing apparatus, it has become common to install a filter for removing basic substances referred to as a chemical filter, in the respective air conditioning systems of the projection exposure apparatus and the coating and developing apparatus.

However, in the coating and developing apparatus, various chemicals are used for process chemicals. For example a decomposition product of a surface preparation agent HMDS used for improving adhesion of the photoresist on the substrate is a basic substance. Therefore if this decomposition product passes through the connecting portion of the in-line construction, and infiltrates into the excimer exposure apparatus, there is a problem in that the amplification operation of the chemical amplification type resist is impaired.

The present invention takes into consideration such points, with the object of providing a coating and developing exposure apparatus which prevents the infiltration from a coating and developing apparatus to a projection exposure apparatus, of substances having an adverse affect on a projection exposure step.

DISCLOSURE OF THE INVENTION

As a means for solving the abovementioned problem, an exposure system according to the present invention comprises: a first unit incorporating a first apparatus (2, 51) for transferring an image of a pattern of a mask onto a substrate, a second unit incorporating a second apparatus (1, 52) having a function different from that of the first apparatus, and a connection unit (15, 53) for connecting the first unit and the second unit, and is characterized in that an internal pressure of the connecting section is set to be lower that an internal pressure of either of the first unit and the second unit, and is set to be higher than a pressure of the surroundings in which the connection unit is installed.

According to the abovementioned exposure system, the first apparatus is a projection exposure apparatus (51) having; a light source for irradiating exposure light, an illumination optical system for illuminating the mask with exposure light from the light source via a light transmission optical system, and a projection optical system for projecting an image of a pattern of an illuminated mask onto the substrate which has been coated with a photosensitive material, and the second apparatus is a coating and developing apparatus (52) for coating the photosensitive material onto the substrate, and developing the photosensitive material on which the image of the pattern has been projected.

Furthermore, the first apparatus is a projection exposure apparatus (2) having an illumination optical system for illuminating the mask, and a projection optical system for projecting an image of a pattern of the illuminated mask onto the substrate, the second apparatus is a light source (1) for irradiating exposure light, and the connection section (15) accommodates a light transmission optical system (4) which guides the exposure light irradiated from the light source to the illumination optical system.

Furthermore, an exposure system according to the present invention comprises: a first unit (2, 51) incorporating a first apparatus for transferring an image of a pattern of a mask onto a substrate, a second unit (1, 52) incorporating a second apparatus having a function different from that of the first apparatus, and a connection unit (15, 53) for connecting the first unit and the second unit, and is characterized in comprising: a gas supplying device (10) for supplying a predetermined gas to inside the connection unit, a first sensor (20) for detecting a condition change of gas inside the connection unit, and a supply quantity regulating apparatus (22) for regulating the predetermined gas supply quantity from the gas supplying device.

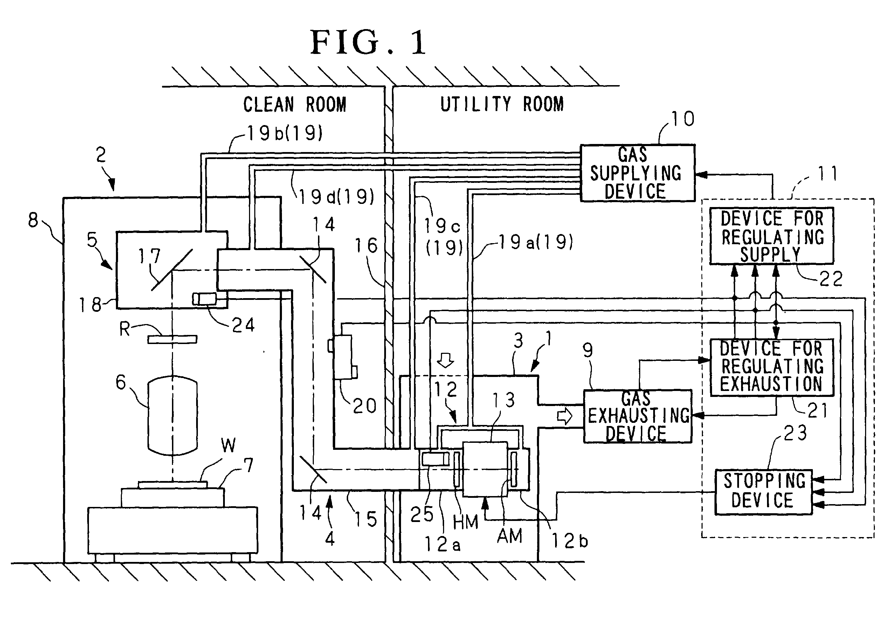

Furthermore, as a means for solving the abovementioned problem, an exposure apparatus having the following construction is adopted. That is to say, the exposure apparatus according to the present invention, as shown in FIG. 1 comprises: an illumination optical system (5) for illuminating a mask (R) with exposure light emitted from a laser unit (1), via a light transmission system (4), and an exposure apparatus main body (2) for projecting an image of the illuminated mask pattern onto a photosensitive substrate (W), and is characterized in comprising: a gas supplying device (10) for supplying an inert gas to inside a casing (15) which accommodates the light transmission system (4), a first detection device (20) for detecting a condition change of the gas inside the casing (15), and a supply quantity regulating device (22) for regulating a supply quantity of inert gas from the gas supplying device (10) based on detection results of the first detection device (20).

According to the abovementioned exposure apparatus, if the inert gas filled inside the casing (15) leaks to the outside from a gap in the optical members so that the pressure of the gas inside the casing (15) drops and the concentration thus changes, the condition change of the gas is detected by the first detection device (20), and the supply quantity of inert gas is regulated based on the resultant detection result. As a result, the interior of the casing (15) is restored to the normal condition.

Here for the first detection device (20), a differential manometer for detecting a pressure difference between the inside and outside of the casing (15), or a plurality of oxygen analyzers are adopted. An arrangement with oxygen analyzers installed at several locations inside the casing (15) is preferable.

Furthermore, a coating and developing exposure apparatus (60) of the present invention is a coating and developing exposure apparatus (60) which is installed inside a clean room (58) and comprises: a projection exposure apparatus (51) having an air conditioning system, for projection exposing an image of a pattern of a mask with exposure illumination light onto a substrate which has been coated with a photosensitive material, via a projection optical system; a coating and developing apparatus (52) having an air conditioning system, for coating the photosensitive material onto the substrate, and developing the photosensitive material on which the image of the pattern has been projection exposed; and a connection section (53) for connecting the projection exposure apparatus (51) and the coating and developing apparatus (52), and is characterized in that an internal pressure of the connection section (53) is set to be lower than an internal pressure of either of the projection exposure apparatus (51) and the coating and developing apparatus (52), and is set to be higher than a pressure of the clean room (58). With such a construction, since the internal pressure of the connection section (53) is set to be lower than the internal pressure of the projection exposure apparatus (51) and the coating and developing apparatus (52), the gas inside the connection section (53) will not infiltrate to inside of the projection exposure apparatus (51) and the coating and developing apparatus (52). Consequently, a coating and developing exposure apparatus can be provided which prevents the infiltration from the coating and developing apparatus (52) to the projection exposure apparatus (51), of substances having an adverse affect on the projection exposure step.

According to the coating and developing exposure apparatus (60), at least one air conditioning system of the air conditioning systems belonging to the projection exposure apparatus (51) and the coating and developing apparatus (52) may be equipped with a chemical filter (54, 55, 56) for removing or deactivating impurities. For the light source of the exposure illumination light of the projection exposure apparatus (51), an excimer laser may be used. With such a coating and developing exposure apparatus (60), in particular in the case where an excimer exposure apparatus is used for the projection exposure apparatus of the coating and developing exposure apparatus, a coating and developing exposure apparatus which suppresses the presence of alkalis which impede the amplification operation of the chemical amplification type resist, can be provided.

BRIEF DESCRIPTION OF THE DRAWINGS

FIG. 1 is an overall structural diagram illustrating an exposure apparatus, being a first embodiment according to the present invention.
FIG. 2 is a schema showing spaces which are filled with nitrogen gas, and the inflow and outflow of nitrogen gas to the respective spaces, in a first exposure apparatus.

FIG. 3 is a schematic diagram showing a coating and developing exposure apparatus, being a second embodiment according to the present invention.

FIG. 4 is a diagram mainly showing an operating principal of an air conditioning system of one example of a coating and developing exposure apparatus according to the present invention.

FIG. 5 is an overall structural diagram showing an example of a conventional exposure apparatus.

FIG. 6 is a schematic diagram showing an example of a coating and developing exposure apparatus of a conventional in-line configuration.

## EMBODIMENTS

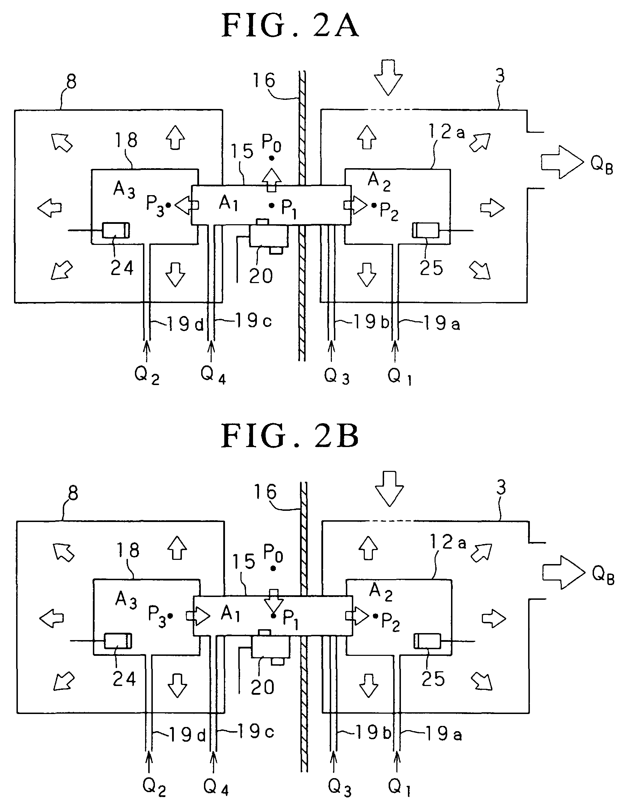

A first embodiment of an exposure apparatus according to the present invention will be described with reference to FIG. 1 and FIG. 2.

FIG. 1 shows the overall construction of an exposure apparatus having a light source such as an ArF excimer laser. In FIG. 1, reference numeral 1 denotes a laser unit, 2 denotes an exposure apparatus main body, 3 denotes a chamber for accommodating a laser oscillator 12, 4 denotes a light transmission system for transmitting laser radiation irradiated from the laser oscillator 12 to the exposure apparatus main body 2, 5 denotes an illumination optical system for irradiating laser radiation which has been transmitted through the light transmission system 4, towards a reticle (mask) R, 6 denotes a projection optical system for projecting a pattern image of the reticle R which has been illuminated by the illumination optical system 5 onto a wafer (photosensitive substrate) W, 7 denotes a wafer stage for moving the wafer W horizontally in two directions, 8 denotes a chamber for accommodating the exposure apparatus main body 2, 9 denotes a gas exhausting device for exhausting gas from inside the chamber 3, 10 denotes a gas supplying device for individually supplying nitrogen gas (inert gas) respectively to optics chambers 12a and 12b furnished with the later described laser oscillator, the light transmission system 4 and the illumination optical system 5, and 11 denotes a control section for controlling operation of the gas exhausting device 9 and the gas supplying device 10 and other operations.

As will be understood from the figure, with the exposure apparatus, the laser unit 1 is installed in a utility room, while the exposure apparatus main body 2 is installed in a clean room adjacent to the utility room. With this installation, the interior of the clean room can be effectively utilized.

The laser unit 1 comprises; the laser oscillator 12 which incorporates a laser reaction chamber including a narrow band module and a discharging electrode, and a chamber 3 for accommodating these. The narrow band module comprises for example an assembly of a prism and a diffraction grating, and optical elements such as an interference type bandpass filter with two resonator mirrors arranged in parallel, referred to as a Fabry-Perot etalon. With the present embodiment, the description is given taking as an example, the case where two resonator mirrors are used. With the two resonator mirrors, one is a fully reflecting type (reflection type resonator minor AM), while the other is half transmission and half reflection type (resonator half mirror HM). The mirror HM and the mirror AM are arranged on either side of a laser reaction chamber 13, and are accommodated inside the optics chambers 12a and 12b. The optics chamber 12a forms a purge space between a lens barrel 15 and the laser reaction chamber 13 for nitrogen gas supplied from the gas supplying device 10.

Furthermore, the laser reaction chamber is filled with a reactive gas such as $F_2$ (fluorine), Kr (Krypton), Ar (Argon), or Ne (Neon). Then, by applying a prescribed voltage to the discharge electrodes, laser radiation is oscillated from the laser reaction chamber, and after this laser radiation has been reflected back and forth between the mirror AM and the mirror HM, this is output to the light transmission system 4.

Moreover, with the gas exhausting device 9, since fluorine gas is used in the laser reaction chamber 13 inside the laser unit 1, then in order to ensure safety, this is provided for exhausting the gas inside the chamber 3 which accommodates the laser oscillator 12, to outside. That is to say, this is provided for the outflow of the fluorine from the gas reaction chamber.

The light transmission system 4 comprises a plurality of optical members including mirrors 14. The respective optical members are arranged (accommodated) inside a lens barrel 15 (casing) which covers the light path. The lens barrel 15 is provided from the laser unit 1, passing though the chamber 3, through a wall 16 separating the clean room and utility room and through the chamber 8. In all of the penetrating portions of the chambers 3 and 8 and the wall 16, a high air tightness is ensured.

The illumination optical system 5 comprises optical members including a mirror 17, and an optical integrator and field stop (neither shown in the figure). These respective optical members also, as with the light transmission system 4, are arranged inside a casing 18 which covers the light path.

With the supply path 19 for respectively supplying nitrogen gas from the gas supplying device 10 to the optics chambers 12a and 12b, the light transmission system 4 and the illumination optical system 5, as well as respective systems involving a supply path 19a connected to the optics chambers 12a and 12b, and a supply path 19b connected to the casing 18, there is provided two systems, namely a supply path 19c connected to a position of the lens barrel 15 close to the laser unit 1, and a supply path 19d connected to a position of the lens barrel 15 close to the exposure apparatus main body 2. Furthermore, the gas supplying device 10 can separately regulate the supply quantity of nitrogen gas to the respective positions of the laser unit 1, the light transmission system 4, and the illumination optical system 5 through the respective supply paths 19a through 19d.

In addition, with the present embodiment, two systems, namely the supply path 19c and the supply path 19d are provided for the lens barrel 15. However, the number of systems is not limited to this. These systems are to improve the supply efficiency of nitrogen gas to inside the lens barrel 15, and to give a uniform purge space inside the lens barrel 15.

A differential manometer (first detection device) 20 is provided on the lens barrel 15 for detecting the pressure difference between the light path and the clean room. An exhaust quantity regulating device 21 is provided in the control section 11 for regulating the exhaust quantity of gas from inside the chamber 3 by means of the gas exhausting device 9, based on detection results of the differential manometer 20.

Furthermore, provided in the control section 11 is a supply quantity regulating device 22 for regulating the supply quantity of nitrogen gas by means of the gas supplying device 10, based on detection results of the differential manometer 20, and a stopping device 23 for stopping the operation of the laser unit 1, similarly based on detection results of the differential manometer 20.

Inside the casing 18 for accommodating the illumination optical system 5 and inside the chamber 3 for accommodating the laser unit 1 (optics chamber 12a) is respectively provided oxygen analyzers 24 and 25 (second and third detection devices) for measuring the oxygen concentration inside the respective pans. The gas supplying device 10 regulates the flow quantity of nitrogen gas to the respective parts of the optics chamber 12a, the light transmission system 4, and the illumination optical system 5 based on the measurement results of these oxygen analyzers 24 and 25. The optics chamber 12b also has the same construction.

According to the exposure apparatus constructed as described above, the condition change of the nitrogen gas inside the optics chamber 12a, the light transmission system 4 and the illumination optical system 5 is shown in FIG. 2. In FIG. 2, the laser reaction chamber 13 and the optics chamber 12b in FIG. 1 are omitted, and only the optics chamber 12a is shown. FIG. 2 schematically shows the spaces which are filled with nitrogen gas in the exposure apparatus interior. A1 denotes a purge space inside the lens barrel 15 constituting the light transmission system 4, A2 denotes a purge space inside the optics chamber 12a, and A3 denotes a purge space inside the casing 18 which accommodates the illumination optical system 5. $A_1$, $A_2$ and $A_3$ constitute transmission paths for the laser radiation necessary for exposure. Air can be go in and out between adjacent respective purge spaces.

Here the pressure inside the clean room is $P_0$, while the pressure inside the purge spaces A1, A2, A3 is respectively $P_1$, $P_2$ and $P_3$. The pressure inside the utility room is the same as the pressure inside the clean room, but is set to be lower than that inside the lens barrel 15 and the chamber 3. Moreover, with the supply paths constituting the nitrogen gas supply system, the flow quantity of nitrogen gas supplied through the supply path 19a to A2 is made Q1, the flow quantity of nitrogen gas supplied through the supply path 19b to A1 is made Q3, the flow quantity of nitrogen gas supplied through the supply path 19c to A1 is made Q4, and the flow quantity of nitrogen gas supplied through the supply path 19d to A3 is made Q2. The exhaust quantity of gas from the chamber 3 is made $Q_B$.

At the time of commencement of exposure, when the high purity nitrogen gas is supplied to $A_1$, $A_2$ and $A_3$, then as shown in FIG. 2 (a) the air and gas containing impurities which is already filled into A1, A2 and A3 is exhausted to the chambers 3 and 8 and the clean room, being pushed out from the small spaces between the respective blocks.

At this time, in order to prevent reverse flow of the gas containing impurities (including the air from the clean room, the utility room, and the chambers), $Q_1$, $Q_2$, $Q_3$ and $Q_4$ are appropriately set so that $P_1$, $P_2$ and $P_3$ are always higher than $P_0$. In addition, since it is desirable that the flow of nitrogen gas produced inside $A_1$, $A_2$ and $A_3$ is in a form from $A_1$ to $A_2$ and $A_3$, then $Q_3$ and $Q_4$ are set to be greater than $Q_1$ and $Q_2$, that is, $P_1$ is set to be higher than $P_2$ and $P_3$.

Incidentally, in the case where the supply of nitrogen gas to $A_1$, $A_2$ and $A_3$ by the gas supplying device 10 is not sufficient, then $P_1$, $P_2$ and $P_3$ gradually drop due to the insufficient supply of nitrogen gas, so that there is the possibility of $P_0 > P_1$ resulting. If $P_0 > P_1$ results, the air inside the clean room flows into $A_1$ from the small gaps in the lens barrel 15. Furthermore, since the air can go in and out between $A_1$, $A_2$ and $A_3$, the overall purge rate for $A_1$, $A_2$ and $A_3$ drops, so that there is the danger of a drop in light transmittance of the laser radiation, and a deterioration in apparatus performance due to reaction with the optical member surfaces and other components.

In this case, with the exposure apparatus, the pressure difference $\Delta P (= P_1 - P_0)$ between $A_1$ and the clean room is constantly detected by the differential manometer 20, and $Q_1$, $Q_2$, $Q_3$ and $Q_4$ are regulated as required based on the value of $\Delta P$ detected by the differential manometer 20. If $\Delta P$ exhibits a positive value above the resolution of the differential manometer 20, it is considered that $P_0 < P_1$, and the condition of FIG. 2 (a) is maintained, while if $\Delta P$ exhibits a value less than the resolution of the differential manometer 20, it is considered that the condition has deteriorated to that of FIG. 2 (b). Then, $Q_1$, $Q_2$, $Q_3$ and $Q_4$ are regulated in the control section 11 so that the exhaust quantity $q < Q_1 + Q_2 + Q_3 + Q_4$ results, and recovery of the

purge rate inside $A_1$, $A_2$, and $A_3$ is achieved. Here with the above explanation it is not necessary to consider the exhaust quantity $Q_B$ of FIG. 2 by the exhausting device.

Furthermore as another embodiment, from the condition of FIG. 2 (a) in the case where $Q_B$ is increased for exhausting gas from inside the chamber 3 (casing), if the air-tightness of $A_2$ and the air-tightness of the part of $A_1$ contained inside the chamber 3 is not sufficient, a pressure drop inside the chamber 3 is experienced due to gas discharge, so that the pressure inside the chamber 3 becomes less. As a result, the supply quantity q of nitrogen gas (containing impurities) discharged from $A_2$ or $A_1$ to inside the chamber 3 increases. If q increases, then as shown in FIG. 2 (b), a flow of nitrogen gas from $A_3$ towards $A_1$ is formed, and in the case where $q > Q_1 + Q_2 + Q_3 + Q_4$ so that the supply of nitrogen gas to $A_1$, $A_2$ and $A_3$ is not sufficient, then similarly there is the possibility that $P_0 > P_1$ will result.

In this case, with the exposure apparatus, $Q_B$ is regulated as required based on the detection results of the differential manometer 20. In the case where based on the detection results of the differential manometer 20 it is considered that $A_1$, $A_2$ and $A_3$ have deteriorated to the condition of FIG. 2 (b), $Q_B$ is adjusted in the exhaust quantity regulating device 21 so that $q < Q_1 + Q_2 + Q_3 + Q_4$, and recovery of the purge rate inside $A_1$, $A_2$ and $A_3$ is achieved.

Furthermore, with the exposure apparatus, the oxygen concentration inside $A_2$ and $A_3$ is constantly detected by the oxygen analyzers 24 and 25, and the operation of the laser unit 1 is stopped as required based on the value of $\Delta P$ detected by the differential manometer 20, or the oxygen concentration detected by respective oxygen analyzers 24 and 25. In the case where based on the detection results from the differential manometer 20, $A_1$, $A_2$ and $A_3$ are considered to have deteriorated to the condition of FIG. 2 (b), or in the case where either one of the oxygen concentrations inside $A_2$ and $A_3$ detected by the oxygen analyzers 24 and 25 exceed a predetermined value, operation of the laser unit 1 is restrained by the stopping device 23 so that the irradiation of laser radiation is temporarily stopped. Then, once the purge rate inside $A_1$, $A_2$ and $A_3$ is restored so that the light transmittance of the laser radiation returns to the normal condition, a restart enable condition for the exposure process results.

As described above, according to the exposure apparatus constructed as mentioned above, the condition of the gas inside the laser unit 1 (optics chamber 12a), the light transmission system 4 and the illumination optical system 5 is always kept constant, and a high light transmittance for the laser radiation is maintained. Therefore stabilized exposure processing can be continued.

In the case where the pressure inside $A_1$, $A_2$ and $A_3$ is not restored even if the supply quantity of nitrogen gas, or the supply pressure, or the gas (casing) exhaust quantity is changed, an alarm or an error signal such as flashing or illumination of a warning lamp can be output. As a result, an investigation of the cause can be made.

Further, in the present embodiment, the differential manometer 20 is provided in the light transmission system 4, for detecting the pressure difference $\Delta P$ between $A_1$ and the clean room, and restoration of the purge rate inside $A_1$, $A_2$ and $A_3$ is achieved by controlling the supply quantity of nitrogen gas to $A_1$, $A_2$ and $A_3$, or by controlling $Q_B$, based on the detection result therefrom. However the same effect is also obtained by arranging a plurality of oxygen analyzers in the light transmission system 4, instead of the differential manometer 20. The oxygen analyzers are respectively installed at respective locations in the lens barrel 15 which constitutes the laser unit 1 and the light transmission system 4 (for example at opposite end portions adjacent to the laser unit 1 and the exposure apparatus main body 2, and on respective side faces of the lens barrel 15 adjacent to the clean room and the utility room), and by controlling or otherwise the supply quantity of nitrogen gas to $A_1$, $A_2$ and $A_3$ corresponding to locations where a rise in oxygen concentration is detected, restoration of the purge rate inside $A_1$, $A_2$ and $A_3$ can be achieved.

Furthermore, flow meters for measuring the flow quantity of nitrogen gas may be provided for each of the supply paths 19c and 19b used for supplying nitrogen gas to inside the lens barrel 15. Moreover, the value of the gas flow quantity at the time when the pressure relation of the pressure $P_0$ for the clean room interior and the pressure $P_1$ for the lens barrel 15 is $P_0 < P_1$, is made a reference. Then, if a fluctuation occurs in the pressure $A_1$ inside the lens barrel 15, a change occurs in the value for the gas flow quantity supplied from the supply paths 19c and 19b. Consequently, the pressure change inside the lens barrel 15 can be detected based on the change in the value of the gas flow quantity. Furthermore, in the case where a change occurs in the value for the gas flow quantity, a signal to this effect is output to the gas supplying device 10, so that even if the gas flow quantity is increased, the pressure relationship can be always made $P_0 < P_1$.

Moreover, according to the present embodiment, nitrogen gas is adopted for purging. However another inert gas, for example dry air where the moisture content had been adjusted chemically by a chemical, or an inert gas such as helium may be used.

With the present embodiment, the description has been for a construction where in the relationship for the pressure $P_1$ of the purge space $A_1$, the pressure $P_2$ of the purge space $A_2$, the pressure $P_3$ of the purge space $A_3$, the pressure $P_1$ is set higher than the pressure $P_2$, and the pressure $P_3$. However, the construction may be such that the pressure of the purge space $A_1$ is $P_1$, and this is set to be lower than the pressure $P_2$ of the purge space $A_2$ and the pressure $P_3$ of

the purge space $A_3$, and also is set to be higher than the pressure of the clean room, or the utility room. In order to maintain this pressure relationship, the gas supply quantity from the gas supplying device 10 may be regulated based on the results of the first, second and third detection devices. By so doing, the inflow and outflow of gas between the purge space $A_2$ and the purge space $A_3$ can be prevented.

Furthermore, according to the present embodiment, the laser unit 1 is installed in the utility room, while the exposure apparatus main body 2 is installed in the clean room adjacent to the utility room. However, the laser unit 1 may be installed in the clean room as with the exposure apparatus main body 2. Furthermore, the laser unit 1 may be installed under the floor of the clean room.

The lens barrel 15, and the optical system accommodated in the casing 18 in the present embodiment, comprise a plurality of optical elements or optical members. However these optical members or optical elements may be respectively arranged inside independent purge spaces.

Even if independent purge spaces are formed in the lens barrel 15 and the casing 18, since it is difficult to form a completely sealed space, this can be dealt with using a similar construction to that of the present embodiment.

Moreover, for the laser used in the abovementioned embodiment, this is not limited to the abovementioned laser light source, and light of any wavelength may be oscillated. For example, an excimer laser having an oscillation spectrum other than for the wavelengths 248 nm, 193 nm, or 157 nm is suitable.

Furthermore, with the projection optical system of the exposure apparatus, this is not limited to a reduction system, and an equal magnification or enlarging type (for example an exposure apparatus for liquid crystal display manufacture) may be used.

Moreover, the exposure apparatus is not only used in the manufacture of semiconductor devices, but may also be applied to exposure apparatus such as; exposure apparatus used in the manufacture of displays including liquid crystal display elements and the like for transferring a device pattern onto a glass plate, exposure apparatus used in the manufacture of thin film magnetic heads for transferring a device pattern onto a ceramic wafer, and exposure apparatus used in the manufacture of image pick-up devices (CCDs etc.). Furthermore, the present invention can also be applied to exposure apparatus for transferring a circuit pattern onto a glass substrate, or a silicon wafer or the like.

The exposure apparatus of the present embodiment can be produced by incorporating an illumination optical system comprising a plurality of lenses, and a projection optical system into an exposure apparatus main body, and performing optical adjustment, and fitting a reticle stage and a wafer stage comprising various mechanical components to the exposure apparatus main body, and connecting wiring and piping, and then performing overall adjustment (electrical adjustment, operation verification etc.). In addition, it is desirable that the production of the exposure apparatus be performed in a clean room wherein the temperature, the degree of cleanliness and the like are controlled.

A semiconductor device is produced through steps such as: a step for designing the function and performance of the device, a step for producing reticles based on the designing step, a step for producing wafers from a silicon material, a step for exposing a pattern of a reticle onto a wafer by means of the exposure apparatus in the above described embodiment, a device assembly step (including a dicing step, a bonding step and a packaging step), and an inspection step. In the above manner, the present invention is not limited to the aforementioned embodiment. Furthermore, constructions with various embodiments assembled as required are also possible.

With the first embodiment, the description has been aimed towards the exposure apparatus incorporating the projection exposure apparatus main body 5 and the laser unit 1, with the lens barrel 15 between these. However the invention is not limited to this. For example, instead of the projection exposure apparatus main body 5, an exposure apparatus main body constructed including the laser unit and the lens barrel 15 may be accommodated inside the chamber 8, and instead of the laser unit 1, this may be a coating and developing apparatus for carrying out unloading and loading of a wafer to and from the exposure apparatus, and coating of a photosensitive material onto the wafer, and developing a pattern image. Furthermore, instead of the lens barrel 15, this may be a connection section for connecting the coating and developing apparatus and the overall exposure apparatus, with the internal pressure set to be lower than the internal pressure of either of the overall exposure apparatus and the coating and developing apparatus, and set to be higher than the pressure of the interior of the clean room.

Also with this construction, in order to keep this pressure relationship, the construction of the present embodiment can be adopted. In this case, the gas exhausting device in the embodiment may be provided in the chamber which accommodates the coating and developing apparatus.

Hereunder is a description of a coating and developing exposure apparatus of a second embodiment according to the present invention, with reference to the drawings.

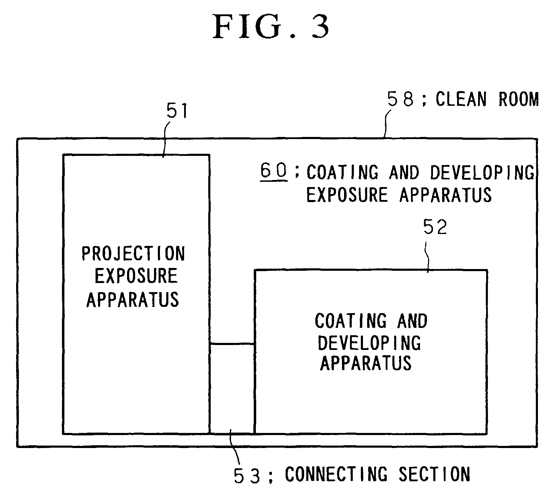

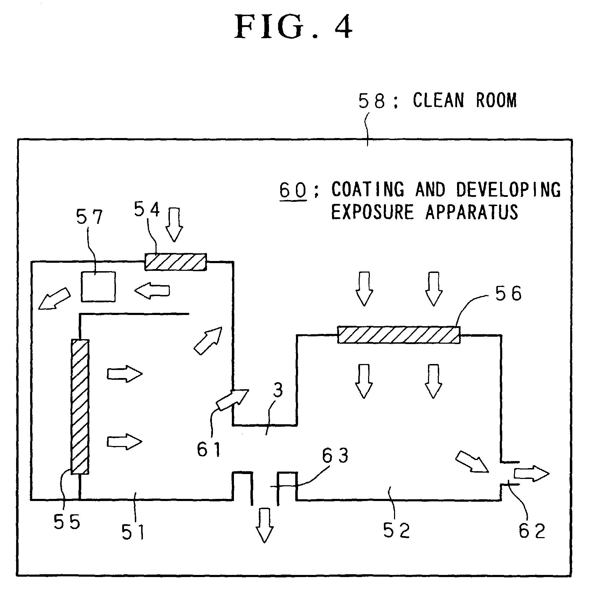

FIG. 3 is a schematic diagram showing an example of an embodiment of a coating and developing exposure apparatus according to the present invention. The construction is such that an internal pressure of a connection section (air conditioning buffer space) 3 for connecting a projection exposure apparatus 51 and a coating and developing apparatus 52, is set to be lower than respective internal pressures of the projection exposure apparatus 51 and the coating and developing apparatus 52, and is set to be higher than the pressure of a clean room 58 in which the coating and developing exposure apparatus 60 is installed. An embodiment of a construction for an air conditioning system for realizing this construction, is described hereunder with reference to FIG. 4.

FIG. 4 is a diagram of an example of a coating and developing exposure apparatus according to the present invention, mainly concerned with the operating principle of an air conditioning system. The arrows on the figure show the direction of flow of air.

Since the projection exposure apparatus 51 does not use contaminating substances such as chemicals thereinside, basically air conditioning is performed by an internal circulation type air conditioning method. With this method, the load on the temperature control system for compensating for operational accuracy of the exposure apparatus, that is the capacity of the heater and cooler can be reduced. Furthermore, the chemically polluted atmosphere (for example an atmosphere with an ammonia ion concentration of from zero to several tens of ppb, being representative of the basic subsntaces) inside the clean room 58 in which the exposure apparatus is installed, is constantly passed through a chemical filter of the air conditioning system of the exposure apparatus, and this can prevent the inconvenience of a shortening of the life of the chemical filter.

More specifically, the chemical filter belonging to the air conditioning system of the projection exposure apparatus 51, comprises chemical filters 54 and 55. The chemical filter 55 is for filtering the air flow circulated inside the projection exposure apparatus 51. With the projection exposure apparatus 51, in order to protect the substrate from contamination by dust and dirt infiltrating in from outside, the internal pressure is set to be higher than the pressure of the clean room 58, and a discharge air flow 61 is produced which passes through structure (micropores etc.) of the casing (chamber) which is not completely sealed.

The chemical filter 54 is installed in an air filter section which brings in air corresponding to the discharge air from the clean room 58, for filtering the air which flows from the clean room 58 into the exposure apparatus 51. The flow of air inside the exposure apparatus is generated by a pressurizing fan blower 57.

Compared to the air conditioning system of the projection exposure apparatus 51, the air conditioning system of the coating and developing apparatus 52 adopts a single pass air conditioning system rather than a circulation system, so that air which contains substances generated from chemicals used thereinside and which has thus been chemically polluted, does not come into contact with the substrate. That is to say, in the air conditioning system of the coating and developing apparatus 52, as well air filtering the air flow introduced from the clean room 58, by a chemical filter 56 installed in the air filter section, this is discharged to the outside though a ventilation port 62 without coming into contact with the substrate which is undergoing processing. The ventilation port 62 is usually connected to an exhaust processing unit at a facility (not shown in the figure) so that chemically polluted gas cannot diffuse back to inside the clean room 58. The air flow is produced by a fan blower 57 (not shown in the figure) installed inside the coating and developing apparatus 52.

The projection exposure apparatus 51 and the coating and developing apparatus 52 constructed as described above are connected to each other via the connection section (air conditioning buffer space) 53. In the connection section 53 there is included a substrate transport or delivery apparatus (not shown in the figure). The connection section 53 has a ventilation port 63. The construction is such that air inside the connection section 53 is exhausted by the negative suction pressure of a clean room exhausting apparatus (not shown in the figure) connected to the ventilation port, or by the exhaust pressure of an exhaust fan (not shown in the figure) installed in the ventilation port.

By adopting such a construction, the internal pressure of the connection section 53 which becomes a buffer space between the projection exposure apparatus 51 and the coating and developing apparatus 52, is lower than the respective internal pressures of the projection exposure apparatus 51 and the coating and developing apparatus 52. Consequently, the flow of air between the projection exposure apparatus 51 and the coating and developing apparatus 52 through the connection section 53 can be intercepted. Furthermore, with this construction, the internal pressure of the connection section 53 is set to be higher than the pressure of the clean room 58. As a result, infiltration of the atmosphere of the clean room 58 which contains dust and dirt or chemically polluted substances, into the connection section 53 is prevented. In the in-line construction of the coating and developing apparatus 52 and the exposure apparatus 51, if the connection section 53 provided with a ventilation port is formed in the normally provided in-line interface section (the small connection room used for substrate transfer or temporary holding), then the abovementioned construction can be conveniently realized.

As the type of filer used here, an organism filter for removing silicon type organic substances (for example siloxane or silazane), an activated charcoal filter for removing plasticizers (phthalic acid ester etc.) and flame retardants (phosphoric acid, chlorine type substances) (for example, "Giga Soap" manufactured by Nitta Ltd. of Japan), or a zeolite filter or the like may be used.

With the second embodiment, the description is given based on a coating and developing exposure apparatus comprising the projection exposure apparatus 51, the coating and developing apparatus 52, and the connection section 53 connecting the projection exposure apparatus 51 and the coating and developing apparatus 52. However, the present embodiment can also be adopted for constructions with a single projection exposure apparatus 51.

Hereunder is a detailed description of such a projection exposure apparatus 51. The projection exposure apparatus 51 comprises overall three parts. The first part is the light source for irradiating exposure light. The second part is the exposure apparatus main body incorporating; an illumination optical system for illuminating a mask with exposure light irradiated from the light source, a projection optical system for transferring an image of a pattern of the illuminated mask onto a substrate, a stage on which the mask is mounted, and a stage on which the substrate is mounted. The third part comprises a light transmission optical system arranged between the light source and the illumination optical system for transmitting exposure light from the light source to the projection optical system. Furthermore, the light source is accommodated inside a laser unit, and the light transmission optical system is accommodated inside a connection unit. The construction is such that these respective units and a main body chamber are installed inside a clean room.

Also with the single projection exposure apparatus constructed in this manner, the respective relationships between the pressure inside the laser unit, the pressure inside the connection unit, and the pressure inside the main frame chamber, as with the present embodiment are extremely important. That is to say, so that impurities inside the clean room do not flow to inside the laser unit, the connection unit, and the main frame chamber, and that gas flow does not occur between the laser unit and the main frame chamber, it is important that even if impurities infiltrate into one part, for example the air inside the main frame chamber, these impurities do not flow out to the laser unit.

Consequently, as a modified example of the second embodiment, the projection exposure apparatus 51 according to the present embodiment may be made a main frame chamber for accommodating a projection exposure apparatus main body, the coating and developing apparatus 2 may be made a laser unit for accommodating a light source, and the connection section may be made a connection unit for accommodating a light transmission optical system.

That is to say, the internal pressure of the lens barrel (connection unit) may be set to be lower than the respective internal pressures of the chamber for accommodating the exposure apparatus main body, and the laser unit side, and may be set to be higher than the pressure of the clean room. With such a construction, even if the entire exposure light path between the exposure apparatus and the laser light is purged, the flow of gas between the projection exposure main body and the laser unit can be prevented. Moreover, mixing of impurities from the exposure apparatus main body or the laser unit with the optical elements constituting the light transmission system can be suppressed, and hence tarnishing of the optical elements can be prevented.

Consequently, according to the present embodiment, the chamber for accommodating the projection exposure apparatus or the exposure apparatus main body may be made a first unit, the chamber for accommodating the laser unit or the coating and developing apparatus may be made a second unit, and the lens barrel or connection portion provided between the first unit and the second unit may be made a connection unit That is to say, the connection unit connects the respective first and second units which accommodate equipment for carrying out different control operations.

Furthermore, for the apparatus for accommodating the second unit, this may be an apparatus of the same construction as the apparatus for accommodating the first unit, with the shape of the pattern of the mask different.

Moreover, the invention is not limited to the first unit and the second unit, and the construction may incorporate a plurality of units. In this case, the apparatus accommodating the plurality of units, may perform the same control operations, or may perform different control operations.

INDUSTRIAL APPLICABILITY

As described, above, with the exposure system according to the present invention, the internal pressure of the connection portion for connecting the first unit and the second unit is set to be lower than the respective internal pressures of the first unit and the second unit. Therefore the infiltration of chemically polluted substances inside the second unit into the first unit can be prevented. Consequently, a substrate or the like inside the exposure system is not contaminated with such substances, and hence a desired semiconductor device or the like can be produced.

Furthermore concerning the temperature stability of the air conditioning inside the exposure system, which has an influence on the operational accuracy (measuring accuracy of the interferometer etc.) of the exposure system, since the flow of air of different temperatures from the second unit to the first unit can be stopped, better temperature stability can be maintained which also contributes to an improvement in operation accuracy.

Moreover, with the exposure apparatus according to the present invention, if the inert gas filled inside the casing leaks to the outside from a gap in the optical members so that the pressure of the gas inside the casing drops and the concentration thus changes, the condition change of the gas inside the casing is detected by the first detection device, and the supply quantity of inert gas is regulated based on the resultant detection result, so that the interior of the casing is restored to the normal condition. As a result, the condition of the gas inside the light transmission system can be always kept constant, and a high light transmittance for the laser radiation is maintained. Therefore stabilized exposure processing can be continued.

In the case where for the first detection device, a differential pressure manometer is provided for detecting the pressure difference between the interior of the casing and the outside, a condition where the pressure inside the casing is less than the pressure outside, that is, a condition where there is a danger of contaminated air flowing from outside to inside the casing, can be quickly detected. Then based on this result, recovery of the pressure inside the casing is achieved. Therefore the condition change of the gas inside the casing can be kept minimal.

In the case where for the first detection device, a plurality of oxygen analyzers located at several positions inside the casing are provided, a condition where the oxygen concentration at various locations inside the casing exceeds a predetermined value, that is, a condition where the light transmittance of the laser light drops due to an increase in oxygen concentration and there is a danger of a deterioration in equipment performance due to reaction with the optical component surfaces or other parts, can be quickly detected. Then based on this result, recovery of the inert gas concentration inside the casing is achieved. Therefore the condition change of the gas inside the casing can be kept minimal.

In the case where there is further provided a stopping device for stopping the operation of the laser unit in the case where a condition change of the gas inside the casing is detected, then in a condition where the light transmittance of the laser light drops, illumination of the laser light is stopped so that exposure in a condition where the light transmittance has dropped is prevented, enabling an improvement in exposure accuracy.

Furthermore, in the case where an exhaust quantity regulating device for regulating the exhaust quantity of gas from the laser unit is provided, then if the pressure of the gas inside the casing drops and the concentration changes, due for example to leakage to the outside of the inert gas filled inside the laser unit and the exposure apparatus main body, from gaps in the optical members, this condition change of the gas inside the casing is detected by the first detection device. Then based on the detection result, the exhaust quantity of unnecessary gas inside the laser unit is regulated to thereby restore the interior of the casing to the normal condition of being filled with inert gas. As a result, the condition of the gas inside the light transmission system can be always kept constant, and a high light transmittance for the laser radiation is maintained. Therefore stabilized exposure processing can be continued.

Furthermore, in the case where a second detection device for detecting a condition change of the gas inside the laser unit, and a third detection device for detecting a condition change in the gas inside the casing which accommodates the exposure optical system is provided, then if the pressure of the gas inside the casing drops and the concentration changes, due for example to leakage to the outside of the inert gas filled inside the laser unit and the exposure apparatus main body, from gaps in the optical members, this condition change of the gas inside the laser unit and the exposure apparatus main body is detected by the second and third detection devices. Then based on the detection result, the supply quantity of inert gas is regulated to thereby restore the interior of the casing to the normal condition of being filled with inert gas. As a result, not only the condition of the gas inside the light transmission system but also the condition inside the light path including the laser unit and the exposure apparatus main body can be always kept constant, and a high light transmittance for the laser radiation is maintained. Therefore stabilized exposure processing can be continued.

Furthermore, with the coating and developing exposure apparatus according to the present invention, since the internal pressure of the connecting portion (air conditioning buffer space) connecting the exposure apparatus and the coating and developing apparatus, is set to be lower than the internal pressure of the respective exposure apparatus and coating and developing apparatus, the chemically polluted substances inside the coating and developing apparatus can be prevented from infiltrating to inside the exposure apparatus. Consequently, a substrate or the like inside the exposure apparatus is not contaminated with these substances, and hence a desired semiconductor device or the like can be produced. This result is particularly significant in the case where in the excimer exposure apparatus which widely uses a chemical amplification type resist as the photosensitive material, a chemical filter is installed in the air conditioning system of the exposure apparatus or the coating and developing apparatus, since the presence of alkalis can be suppressed.

Furthermore concerning the temperature stability of the air conditioning inside the exposure apparatus, which has an influence on the operational accuracy (measuring accuracy of the interferometer etc.) of the exposure apparatus, since the flow of air of different temperatures from the coating and developing apparatus to the exposure apparatus can be stopped, better temperature stability can be maintained which also contributes to an improvement in operation accuracy.

Moreover, in the case where a chemical filter is installed in the air conditioning system of the exposure apparatus or the coating and developing apparatus, then air which has been chemically filtered flows into the connection portion (air conditioning buffer space). Therefore, this also produces the effect of promoting the chemical filtering of the connection portion (air conditioning buffer space).

**Claims**

1. An exposure system comprising:

   a first unit that has a first apparatus for transferring an image of a pattern of a mask onto a substrate,
   a second unit that has a second apparatus having a function different from that of said first apparatus, and
   a connection unit that connects said first unit and said second unit,
   wherein an internal pressure of said connecting section is set to be lower that an internal pressure of either of said first unit and said second unit, and is set to be higher than a pressure of the surroundings in which said connection unit is installed.

2. An exposure apparatus according to claim 1, wherein

   said first apparatus is a projection exposure apparatus comprising; a light source that irradiates exposure light, an illumination optical system that illuminates said mask with exposure light from said light source via a light transmission optical system, and a projection optical system that projects an image of a pattern of said illuminated mask onto said substrate which has been coated with a photosensitive material, and
   said the second apparatus is a coating and developing apparatus that coats said photosensitive material onto said substrate, and develops said photosensitive material on which the image of said pattern has been projected.

3. An exposure system according to claim 1, wherein

   said first apparatus is a projection exposure apparatus comprising an illumination optical system that illuminates said mask, and a projection optical system that projects an image of a pattern of said illuminated mask onto said substrate,
   said second apparatus is a light source for irradiating exposure light, and
   said connection section accommodates a light transmission optical system which guides said exposure light irradiated from said light source to said illumination optical system.

4. An exposure system having a first unit that includes a first apparatus for transferring an image of a pattern of a mask onto a substrate, a second unit that includes a second apparatus having a function different from that of said first apparatus, and a connection unit that connects said first unit and said second unit, said exposure system comprising:

   a gas supplying device that supplies a predetermined gas to inside said connection unit, a first sensor that detects a condition change of gas inside said connection unit, and a supply quantity regulating apparatus that regulates said predetermined gas supply quantity from said gas supplying device.

5. An exposure apparatus according to claim 4, wherein

   said first apparatus is a projection exposure apparatus having a light source that irradiates exposure light, an illumination optical system that illuminates said mask with exposure light from said light source via a light transmission optical system, and a projection optical system that projects an image of a pattern of said illuminated mask onto said substrate which has been coated with a photosensitive material,
   and said the second apparatus is a coating and developing apparatus that coats said photosensitive material onto said substrate, and develops said photosensitive material on which the image of said pattern has been projected.

6. An exposure system according to claim 4, wherein

   said first apparatus is a projection exposure apparatus having an illumination optical system that illuminates said mask, and a projection optical system that projects an image of a pattern of said illuminated mask onto said substrate,
   said second apparatus is a light source that irradiates exposure light, and
   said connection section accommodates a light transmission optical system which guides said exposure light irradiated from said light source to said illumination optical system.

7. An exposure apparatus having an illumination optical system that illuminates a mask with exposure light emitted from a laser unit, via a light transmission optical system, which projects an image of the illuminated mask pattern onto a photosensitive substrate, said apparatus comprising:

   gas supplying device that supplies an inert gas to inside a casing which accommodates said light transmission system, first detection device that detects a condition change of the gas inside said casing, and supply quantity regulating device that regulates a supply quantity of inert gas from said gas supplying device based on detection results of said first detection device.

8. An exposure apparatus according to claim 7, wherein for said first detection device, a differential manometer that detects a pressure difference between the inside and outside of said casing is provided.

9. An exposure apparatus according to claim 7, wherein for said first detection device a plurality of oxygen analyzers are arranged inside said casing.

10. An exposure apparatus according to either one of claim 7, 8, and 9, wherein there is provided a stopping device that stops the operation of said laser unit in the case where a condition change of the gas inside said casing is detected by said first detection device.

11. An exposure apparatus according to any one of claims 7, 8, 9, and 10, wherein there is provided gas exhausting device that exhausts unnecessary gas from said laser unit, and exhaust quantity regulating device that regulates the exhaust quantity of gas from said laser unit based on detection results of said first detection device.

12. An exposure apparatus according to any one of claims 7, 8, 9, and 10, wherein

said gas supplying device provides two systems, namely a system that supplies inert gas to inside said laser unit and a system that supplies inert gas to inside said casing which accommodates said illumination optical system,
and there is provided second detection device that detects a condition change of gas inside said laser unit and third detection device that detects a condition change of gas inside said casing which accommodates said illumination optical system, and
said supply quantity regulating device regulates a supply quantity of inert gas to each of the systems of said gas supplying device based on detection results of said second and third detection device.

13. A coating and developing exposure apparatus installed inside a clean room and comprising: a projection exposure apparatus having an air conditioning system, for projection exposing an image of a pattern of a mask with exposure illumination light onto a substrate which has been coated with a photosensitive material, via a projection optical system;

a coating and developing apparatus having an air conditioning system, that coats said photosensitive material onto said substrate, and develops said photosensitive material on which the image of said pattern has been projection exposed; and a connection section that connects said projection exposure apparatus and said coating and developing apparatus, wherein

an internal pressure of said connection section is set to be lower than an internal pressure of either of said projection exposure apparatus and said coating and developing apparatus, and is set to be higher than a pressure of said clean room.

14. A coating and developing exposure apparatus according to claim 13, wherein at least one air conditioning systems of said air conditioning systems belonging to said projection exposure apparatus and said coating and developing apparatus is equipped with a chemical filter for removing or deactivating impurities.

15. A coating and developing exposure apparatus according to either one of claim 13 and claim 14, wherein for the light source of said exposure illumination light an excimer laser is used.

# FIG. 1

# FIG. 2A

# FIG. 2B

# FIG. 3

58 ; CLEAN ROOM

51

60 ; COATING AND DEVELOPING
EXPOSURE APPARATUS

52

PROJECTION
EXPOSURE
APPARATUS

COATING AND
DEVELOPING
APPARATUS

53 ; CONNECTING SECTION

# FIG. 4

58: CLEAN ROOM

60: COATING AND DEVELOPING
EXPOSURE APPARATUS

57    54

56

3

61

63

55    51    52    62

# FIG. 5

CLEAN ROOM | UTILITY ROOM

GAS SUPPLYING DEVICE — 40

32

38

35

45

46

R

36

W

37

43

43

34

44

LASER OSCILLATOR

41

33 31

GAS EXHAUSTING DEVICE

39

# FIG. 6

58 ; CLEAN ROOM

51

PROJECTION
EXPOSURE
APPARATUS

52

COATING AND
DEVELOPING
APPARATUS

## INTERNATIONAL SEARCH REPORT

| International application No. |
| --- |
| PCT/JP99/00142 |

**A. CLASSIFICATION OF SUBJECT MATTER**
Int.Cl⁶ H01L21/027

According to International Patent Classification (IPC) or to both national classification and IPC

**B. FIELDS SEARCHED**

Minimum documentation searched (classification system followed by classification symbols)
Int.Cl⁶ H01L21/027

Documentation searched other than minimum documentation to the extent that such documents are included in the fields searched
Jitsuyo Shinan Koho            1989-1998
Kokai Jitsuyo Shinan Koho    1989-1998

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP, 2-210813, A (Canon Inc.), 22 August, 1990 (22. 08. 90), All pages (Family: none) | 4, 6-11 |
| X | JP, 9-186077, A (Canon Inc.), 15 July, 1997 (15. 07. 97), All pages (Family: none) | 4, 6-11 |

☐ Further documents are listed in the continuation of Box C.    ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| 25 March, 1999 (25. 03. 99) | 6 April, 1999 (06. 04. 99) |

| Name and mailing address of the ISA/ | Authorized officer |
| --- | --- |
| Japanese Patent Office | |
| Facsimile No. | Telephone No. |

Form PCT/ISA/210 (second sheet) (July 1992)